# EUROPÄISCHE PATENTSCHRIFT

(11) **EP 3 510 180 B1**
(45) Veröffentlichungstag und Bekanntmachung des Hinweises auf die Patenterteilung: **27.01.2021**
(21) Anmeldenummer: 17807714.5
(22) Anmeldetag: 07.11.2017
(51) Int. Cl.: C23C 28/00, C23C 14/06

(54) **VERDICHTERSCHAUFEL MIT MEHRLAGIGEN ALUMINIUMHALTIGEN SCHUTZBESCHICHTUNG**
COMPRESSOR BLADE WITH MULTILAYER ALUMINUM-CONTAINING PROTECTIVE COATING
PALE DE COMPRESSEUR AVEC REVÊTEMENT PROTECTEUR MULTICOUCHE CONTENANT DE L'ALUMINIUM

(30) Priorität: 14.11.2016 DE 102016222296
(43) Veröffentlichungstag der Anmeldung: 17.07.2019
(73) Patentinhaber: Siemens Energy Global GmbH & Co. KG, 81739 München (DE)
(72) Erfinder: FLORES RENTERIA, Arturo, 12161 Berlin (DE); FRIEDLE, Simone, 42285 Wuppertal (DE); NEDDEMEYER, Torsten, 14612 Falkensee (DE)
(86) Internationale Anmeldenummer: PCT/EP2017/078455
(87) Internationale Veröffentlichungsnummer: WO 2018/087080

(56) Entgegenhaltungen:
- EP-A1- 2 907 888
- EP-A1- 3 018 233
- WO-A1-2009/031958
- JP-B2- 2 979 921
- LI CHEN ET AL: "Effect of bilayer period on structure, mechanical and thermal properties of TiAlN/AlTiN multilayer coatings", THIN SOLID FILMS, Bd. 592, 24. September 2015 (2015-09-24), Seiten 207-214, XP055436295, AMSTERDAM, NL ISSN: 0040-6090, DOI: 10.1016/j.tsf.2015.09.029

## Beschreibung

Die Erfindung betrifft eine Verdichterschaufel mit einer Schutzschicht, die zumindest zweilagig ausgebildet ist.

Um Verdichterbauteile von Gasturbinen vor Korrosionsangriff zu schützen, wird oft ein aluminiumpartikelhaltiger Hochtemperaturlack eingesetzt. Da die Beschichtung eine geringe Integralhärte aufweist (ca. 50 Hv), ist auch die Erosionsbeständigkeit wegen Partikelerosion oder Tropfenschlagerosion relativ niedrig. Die geringe Integralhärte ist vor allem durch die weichen Aluminium-Partikel in der Schicht verursacht. Dies hat als Ergebnis, dass diese Bauteile regelmäßig entschichtet, geprüft und neubeschichtet werden müssen. Aktuell werden diese Bauteile in bestimmten Zeitintervallen nach Erosion inspiziert und falls erforderlich, entschichtet und mit dem gleichen Beschichtungssystem neubeschichtet.

EP 2 907 888 A1 offenbart eine Verdichterschaufel aus Stahl, enthaltend eine Al-Diffusionsunterschicht und eine Hartstoffbeschichtung, die aus TiN, TiAlN, AlTiN, CrN als Ein- oder Mehrschichtkeramiken besteht oder TiN, TiAlN, AlTiN, CrN als Mehrschichtkeramiken enthält.

WO 2009/031958 A1, JP 2 979921 B2 und EP 3 018 233 A1 offenbaren Schneidwerkzeuge aus Schnellarbeitstählen mit alternierenden AlTiN und TiAlN Schichten. LI CHEN et al. offenbart in "Effect of bilayer period on structure, mechanical and thermal properties of TiAlN/AlTiN multilayer coatings" (THIN SOLID FILMS, Bd. 592, 24. September 2015 (2015-09-24), Seiten 207-214) eine mehrlagige TiAlN/AlTiN Schicht auf unterschiedliche Substrate.

Es ist daher Aufgabe der Erfindung o. g. Problem zu lösen.

Die Aufgabe wird gelöst durch eine Verdichterschaufel gemäß Anspruch 1 In den Unteransprüchen sind weitere vorteilhafte Maßnahmen aufgelistet, die beliebig miteinander kombiniert werden können, um weitere Vorteile zu erzielen.

Eine Verbesserung der Erosionsbeständigkeit wird dazu führen, dass die Refurbishmentintervalle verlängert werden können und somit Wettbewerbsvorteile erzielt werden.

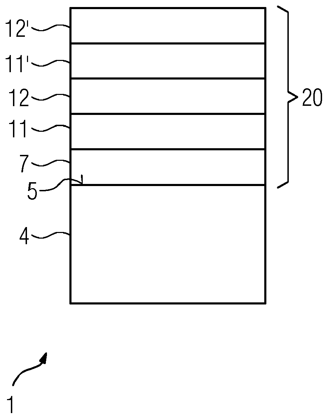

Die Figur und die Beschreibung stellen nur Ausführungsbeispiele der Erfindung dar.

Um die Erosionsbeständigkeit zu erhöhen, wird vorgeschlagen, ein Beschichtungssystem, nämlich aluminiumpartikelhaltiger

Hochtemperaturlack aus dem Stand der Technik, durch ein neues Beschichtungssystem zu ersetzen. Das neue Beschichtungssystem besteht aus einer weichen Grundschicht (Al, Zr, Al-Zr oder Al- bzw. Zr-Legierung), die dem Substrat kathodischen Korrosionsschutz bietet und eine harte (TiAlN) / zähe (AlTiN) viellagige Deckschicht mit erhöhter Korrosion und Erosionsbeständigkeit.

Somit wird das neue Beschichtungssystem eine erhöhte Erosionsbeständigkeit bieten, wobei der Korrosionsschutz gleich wie bei dem aktuellen Schichtsystem erhalten wird.

Ein weiterer Vorteil ist, dass die Aufprallenergie der Partikel oder Wassertropfen in der AlTiN-Schicht mit höherer Zähigkeit "absorbiert" wird, und zusammen mit der härteren TiAlN-Schicht als viellagiges Schichtsystem die Erosionsbeständigkeit der beschichteten Bauteile erhöht wird.

Weitere Vorteile solcher Schichten sind:
- Grundschicht und Deckschicht können in einem Beschichtungsprozess durchgeführt werden (wie z.B. PVD, Sputtering, etc.).
- Das Entschichten, falls erforderlich, kann chemisch erfolgen, da die Grundschicht alleine eine sehr niedrige Korrosionsbeständigkeit hat.

Das vorgeschlagene Schichtsystem weist eine weiche Grundschicht als kathodischen Korrosionsschutz und eine harte Deckschicht als Erosionsschutz auf. Zusammen aufgebracht stellen solche Schichten einen Synergie-Effekt dar. Die weiche Schicht wird die Aufprallenergie der Partikel/Tropfen "absorbieren" und somit wird die Erosionsbeständigkeit der Deckschicht noch höher und die harte Deckschicht besitzt eine erhöhte Korrosionsbeständigkeit und schützt somit die Grundschicht und das Substrat gegen Korrosionsangriff.

So eine Schicht kann durch Anwendung von PVD-Beschichtungsverfahren aufgebracht werden, wobei die Schichtdicke 10µm - 20µm betragen kann und somit bauteilkonturtreu bleibt.

Eine Wärmebehandlung der Schicht ist nicht erforderlich.

Die Rauheit der PVD-Schichten ist bekannterweise gering, was aus aerodynamischer Sicht Vorteile bringen wird.

Die Figur zeigt eine erfindungsgemäße Schicht 20, die bei Verdichterschaufeln von Turbinen, insbesondere Gasturbinen eingesetzt wird.

Eine Verdichterschaufel 1 mit dem Schutzschichtsystem 20 weist ein metallisches Substrat 4 auf.

Das Material des Substrats 4 ist vorzugsweise ein Stahl, wie er auch bei Kompressorschaufeln für Turbinen, Gasturbinen oder für Verdichter eingesetzt wird.

Auf die Oberfläche 5 des Substrats 4 wird direkt eine aluminiumhaltige oder zirkonhaltige Unterschicht 7 aufgetragen. Vorzugsweise gibt es nur eine Unterschicht 7.

Die Unterschicht 7 kann nur Aluminium (Al) oder eine Aluminium-Zirkon-Legierung (Al-Zr) oder nur Zirkon (Zr) oder eine Zirkon-Legierung aufweisen.

Die Unterschicht 7 liegt vorzugsweise zumindest teilweise als Diffusionsschicht vor.

Als äußerste Schicht wird eine TiAlN-Schicht 11 und AlTiN-Schicht 12 aufgebracht.

Vorzugsweise werden Mehrfachlagen aus TiAlN-Schichten 11, 11' und AlTiN-Schichten 12, 12' alternierend aufgebracht.

Es wird nur TiAlN und AlTiN verwendet.

## Patentansprüche

1. Verdichterschaufel (20; 7, 11, 12, 11', 12', ...),
die eine unterliegende
aluminiumhaltige oder zirkonhaltige
Unterschicht (7)
auf einem metallischen Substrat (4) aufweist,
direkt auf und/oder in dem Substrat (4),
wobei die Unterschicht (7) nur
Aluminium (Al) oder
eine Aluminium-Zirkon-Legierung oder
nur Zirkon (Zr) oder
eine Zirkon-Legierung aufweist und
eine äußere mehrlagige, alternierende Deckschicht (11, 12, 11', 12', ...) aus TiAlN-Schichten (11, 11', ...) und AlTiN-Schichten (12, 12', ...) aufweist,
die (11, 12, 11', 12', ...) insbesondere durch PVD aufgebracht wurde.

2. Verdichterschaufel nach Anspruch 1,
die nur eine Unterschicht (7) aufweist,
insbesondere nur eine aluminiumhaltige Unterschicht (7) aufweist.

3. Verdichterschaufel nach Anspruch 1, bei der das metallische Substrat ein Stahl aufweist.

4. Verdichterschaufel nach Anspruch 1, bei der die Unterschicht (7) zumindest teilweise als Diffusionsschicht ausgebildet ist.

## Claims

1. Compressor blade (20; 7, 11, 12, 11', 12', ...), which has an underlying aluminium-containing or zirconium-containing sub-layer (7) on a metallic substrate (4), directly on and/or in the substrate (4),
wherein the sub-layer (7) comprises only aluminium (Al) or an aluminium-zirconium alloy or only zirconium (Zr) or a zirconium alloy and has an outer multilayered, alternating cover layer (11, 12, 11', 12', ...) composed of TiAlN layers (11, 11', ...) and AlTiN layers (12, 12', ...), which (11, 12, 11', 12', ...) has been applied in particular by PVD.

2. Compressor blade according to Claim 1,
which has only one sub-layer (7), in particular has only one aluminium-containing sub-layer (7).

3. Compressor blade according to Claim 1,
in which the metallic substrate comprises a steel.

4. Compressor blade according to Claim 1,
in which the sub-layer (7) is designed at least partially as a diffusion layer.

## Revendications

1. Pale (20 ; 7, 11, 12, 11', 12', ...) de compresseur,
qui a une couche (7) inférieure sous-jacente, contenant de l'aluminium ou du zirconium,
sur un substrat (4) métallique,
directement sur et/ou dans le substrat (4),
la couche (7) inférieure n'ayant que
de l'aluminium (Al) ou
un alliage d'aluminium et de zirconium ou
que du zirconium (Zr) ou
un alliage de zirconium et
une couche (11, 12, 11', 12', ...) de finition extérieure à plusieurs strates en alternance, en des couches (11, 11', ...) de TiAlN et en des couches (12, 12', ...) d'AlTiN,
qui (11, 12, 11', 12', ...) ont été déposées notamment par PVD.

2. Pale de compresseur suivant la revendication 1,
qui n'a qu'une couche (7) inférieure,
en n'ayant notamment qu'une couche (7) inférieure contenant de l'aluminium.

3. Pale de compresseur suivant la revendication 1,
dans laquelle le substrat métallique comporte un acier.

4. Pale de compresseur suivant la revendication 1,
dans laquelle la couche (7) inférieure est constituée, au moins en partie, sous la forme d'une couche de diffusion.
